# EUROPÄISCHE PATENTANMELDUNG

(11) **EP 2 485 346 A2**
(43) Veröffentlichungstag der Anmeldung: **08.08.2012**
(21) Anmeldenummer: 12151677.7
(22) Anmeldetag: 19.01.2012
(51) Int. Cl.: H01S 5/40

(54) **Klemmtechnik für horizontale Montage von Laser-Dioden-Barren**

(30) Priorität: 20.01.2011 DE 102011009018
(71) Anmelder: Clean Lasersysteme Gmbh, 52134 Herzogenrath (DE); Betewis GmbH, 52074 Aachen (DE)
(72) Erfinder: Barkhausen, Winfried Dr., 52074 Aachen (DE); Becker, Christoph Dr., 52074 Aachen (DE); Büchter, Edwin Dipl.-Ing., Dipl.-Kfm, 52134 Herzogenrath (DE); Göhre, Mario, 52146 Würselen (DE); Knöppel, Werner, 52064 Aachen (DE)
(74) Vertreter: Müller & Schubert

(57) **Zusammenfassung**

Die vorliegende Erfindung betrifft insbesondere eine Haltevorrichtung (1) zum horizontalen Befestigen von mindestens zwei in einer Linie nebeneinander angeordneten von Laser-Dioden-Barren (100, 101, 102, 103), wobei die Haltevorrichtung (1) wenigstens ein Kühlisolator-Element (10) für eine elektrische Isolierung und für eine Wärmeanbindung zu einer Kühlsenke in einer ersten Ausführungsform und/oder wenigstens eine Einrichtung (11) zum Klemmbefestigen, insbesondere eine Kontaktfahne (12) aus duktilem Material, zur elektrischen Kontaktierung der Laser-Dioden-Barren (100, 101, 102, 103) in einer zweiten Ausführungsform aufweist. Ferner betrifft die vorliegende Erfindung eine Befestigungsvorrichtung (2) zum horizontalen Befestigen von wenigstens zwei in einer Linie nebeneinander angeordneten Laser-Dioden-Barren (100, 101, 102, 103), wobei die Befestigungsvorrichtung (2) eine entsprechende Haltevorrichtung (1) umfasst. Darüber hinaus umfasst die vorliegende Erfindung eine Laser-Dioden-Einheit (3) mit entsprechend angeordneten Laser-Dioden-Barren (100, 101, 102, 103), die eine entsprechende Haltevorrichtung (1) oder eine entsprechende Befestigungsvorrichtung (2) aufweist, sowie ein Verfahren zum Herstellen einer solchen Laser-Dioden-Einheit (3).

## Beschreibung

Die vorliegende Erfindung betrifft eine Haltevorrichtung zum horizontalen Befestigen von wenigstens zwei in einer Linie nebeneinander angeordneten Laser-Dioden-Barren gemäß dem Oberbegriff von Patentanspruchs 1. Weiterhin betrifft die Erfindung eine Befestigungsvorrichtung zum horizontalen Befestigen von wenigstens zwei in einer Linie nebeneinander angeordneten Laser-Dioden-Barren gemäß dem Oberbegriff von Patentanspruch 5. Ferner betrifft die vorliegende Erfindung eine Laser-Dioden-Einheit gemäß dem Oberbegriff von Patentanspruchs 10, sowie ein Verfahren zum Herstellen einer Laser-Dioden-Einheit gemäß dem Oberbegriff von Patentanspruchs 13.

Da einzelne Laser-Dioden für die Lasertechnik nur bis zu Leistungen von einigen Watt gefertigt werden können, werden oft mehrere Laser-Dioden elektrisch und optisch zusammengefasst. In diesen Fällen werden oftmals Barren verwendet, die beispielsweise auf einem streifenförmigen Chip mehrere Einzelemitter nebeneinander enthalten, wobei verschiedene Anordnungsprinzipien von Laser-Dioden auf den Barren existieren. Die hergestellten Laser-Dioden-Barren werden zur Verwendung angeordnet, wobei hierfür bereits verschiedene Ausführungsformen existieren.

In der US 5,978,396 wird ein Verfahren zum vertikalen Klemmen von Laser-Dioden-Barren vorgestellt. Hierbei wird eine Anzahl von Laser-Dioden-Barren vertikal übereinander zwischen zwei elektrischen Kontakten angeordnet und mit einer Klemm-Schraube zusammengepresst. Die Ableitung der Abwärme geschieht über Wärme-Ableiter an der hinteren Stirnseite der Laser-Dioden-Barren. Aufgrund der kleinen Kontaktfläche des Wärme-Ableiters zum Laser-Dioden-Barren ist die Wärmeableitung aus dem Laser-Dioden-Barren sehr begrenzt. Ein Betrieb des Laser-Dioden-Barrens ist daher nur im Pulsbetrieb möglich. Als ein typisches Beispiel wird der Betrieb bei einer Pulsfrequenz von 30 Hz und einer Pulsdauer von 100 µs beschrieben. Dies entspricht einem "Austastverhältnis" von 0,003. Die erreichbaren Pulsleistungen von 600 W entsprechen demnach einer mittleren Ausgangsleistung des Laser-Dioden-Barrens von 1,8 W. Diese Ausgangsleistung ist für das Seit-Pumpen von Festkörperlasern nicht ausreichend. Höhere Ausgangsleistungen sind mit dieser Anordnung nicht erreichbar, da bereits bei kleinen Ausgangsleistungen von 1,8 W eine Temperaturerhöhung von 4 °C auftritt. Typische Ausgangsleistungen für das Seit-Pumpen von Festkörperlasern liegen im Bereich 40-120 W pro Laser-Dioden-Barren, das heißt etwa um einen Faktor 20-60 höher.

In der US 6,151,341 ist ein Verfahren für das vertikale Anordnen von Laser-Dioden-Barren vorgestellt. Bei diesem Verfahren sind die einzelnen Laser-Dioden-Barren auf jeweils einem Trägerelement angeordnet auf denen sie, konventionell, durch Löten befestigt sind. Die Lötung dient der mechanischen Fixierung und der Wärmeanbindung. Die elektrische Kontaktierung ist ebenfalls konventionell mit Bond-Drähten ausgeführt. Die einzelnen Schubladen beinhalten Kühlkanäle zur Kühlung der Laser-Dioden und Dichtungen. Der Kühlkreislauf wird durch das Übereinanderstapeln und Verpressen der Trägerelemente auf einfache Weise abgedichtet. Einzelne Elemente, zum Beispiel Laser-Dioden-Barren auf einem Trägerelement, können auf einfache Weise getestet, ausgetauscht und repariert werden.

In der US 6,245,589 wird eine Kühlvorrichtung für die Kühlung von Laser-Dioden-Barren vorgestellt. Die Vorrichtung entspricht den heute vielfach zur Kühlung von Laser-Dioden eingesetzten so genannten Mikrokanalkühlern. Auf den Kühlvorrichtungen werden die Laser-Dioden ebenfalls durch Lötung befestigt und die elektrische Kontaktierung ebenfalls mittels Bonden hergestellt. Die einzelnen identisch vorgefertigten Elemente werden mittels Druckschrauben zusammengedrückt. Die Anordnung erlaubt die zusätzliche Anbringung eines optischen Elements zur Kollimierung der Laserstrahlung zum Beispiel eines Zylinderlinsen-Arrays.

In der EP 1 341 275 B1 werden mindestens zwei Laserchips in Form von HalbleiterLaser-Dioden-Barren durch reines Klemmen sowohl mechanisch positioniert, wie auch wärmetechnisch angeschlossen, wie auch elektrisch kontaktiert. Es kommen keine Lötverbindung und keine Bond-Drähte zwischen den Laser-Dioden-Barren und dem Träger zum Einsatz. Zwei Laser-Dioden-Barren werden zwischen den beiden äußeren und einer inneren Elektrode vertikal eingeklemmt. Die beiden äußeren Elektroden sind mit Kühlflüssigkeit durchströmt und stellen damit, über die flächige einseitige Anpressung, die Wärme-Abfuhr aus den Laser-Dioden-Barren dar. Als Zwischenlage sind Isoliertrennstücke vorgesehen, die zum einen die elektrischen Kontakte gegeneinander isolieren und zum weiteren als mechanische Auflage für das Fixieren dienen. Das Klemmen dieser vertikalen Laser-Dioden erfolgt durch eine oder mehrere Zug-Schraube(n).

In der US 5,913,108 wird ein Verfahren zum Konfektionieren von Laser-Dioden-Barren vorgestellt. In dieser Veröffentlichung wird ein Laser-Dioden-Barren beidseitig an Kühlsenken mit einer Lötverbindung angebunden. Beide Kühlsenken sind auf einem gemeinsamen Substrat, welches vorzugsweise nichtleitend ausgeführt ist. Dieses Substrat wiederum ist mittels Lötung auf einer Kühlsenke angebracht. Bei diesem Verfahren gelingt es zwar die Kühlsenken gegenüber der Laser-Diode elektrisch isoliert aufzubauen, alle Verbindungen sind allerdings-konstruktionsbedingt - in Lötverbindungstechnik auszuführen. Hierdurch wird mechanischer Stress in die Laserdioden eingebracht oder Lötspritzer können auf die Austritts-Facette der Laser-Diode gelangen. Beides führt zu einem schnelleren Altern der Laser-Dioden mit der Gefahr eines Frühausfalles des Laser-Dioden-Barrens. Darüber hinaus ist der Lötprozess ein technisch und wirtschaftlich aufwendiges Verfahren. Eine horizontale Anordnung von einzelnen Laser-Dioden-Barren ist mit diesem Verfahren möglich.

In der EP 1 341 275 B1 erlaubt der konstruktive Aufbau prinzipiell eine horizontale Anordnung von Laser-Dioden-Barren. Sowohl die mechanische Positionierung wie auch die elektrische Kontaktierung kommen ohne Lötung und/oder ohne Bond-Verbindung aus. Nachteilig dabei ist jedoch die Kombination von Kühlung und elektrischer Kontaktierung in einem Element. Hierdurch ist das Kühlmedium selbst im Kontakt zur Stromführung. Die hat wesentliche Nachteile bezüglich des einzusetzenden Kühlsystems, welches zwingend mit nichtleitenden Kühlmedien, zum Beispiel de-ionisiertem Wasser betrieben werden muss. Hierdurch wiederum kommt es zu Materialunverträglichkeiten mit weiteren sich im Kühlkreis befindlichen Bauteilen. Darüber hinaus ist der dargestellte Aufbau für das "vertikale Stacken" von Laser-Dioden-Barren optimiert. Konstruktionsbedingt lässt sich eine nahezu beliebige Anzahl von Laser-Dioden-Barren vertikal übereinander stapeln und durch Klemmen verbinden. Eine horizontale Anordnung der Laser-Dioden-Barren ist nicht vorgesehen.

Ausgehend vom genannten Stand der Technik liegt der vorliegenden Erfindung daher die Aufgabe zugrunde, eine konstruktiv einfache horizontale Anordnung und Fixierung von Laser-Dioden-Barren zu ermöglichen, wobei zum einen mehrere Laser-Dioden-Barren horizontal in einer Linie nebeneinander angeordnet und dauerhaft gehalten werden können, zum andern die Anordnung und Fixierung der Laser-Dioden-Barren bei Bedarf lösbar sind. Insbesondere sollen die vorstehend beschriebenen Nachteile vermieden. Zudem soll es möglich sein, jeden der im Allgemeinen. sehr teuren Laser-Dioden-Barren, beispielsweise im Falle eines Defektes, einzelnen auszutauschen.

Diese Aufgabe wird erfindungsgemäß gelöst durch die Haltevorrichtung zum horizontalen Befestigen von wenigstens zwei in einer Linie nebeneinander angeordneten Laser-Dioden-Barren mit den Merkmalen gemäß des unabhängigen Patentanspruchs 1, durch die Befestigungsvorrichtung zum horizontalen Befestigen von wenigstens zwei in einer Linie nebeneinander angeordneten Laser-Dioden-Barren mit den Merkmalen gemäß des unabhängigen Patentanspruchs 5, durch die Laser-Dioden-Einheit mit den Merkmalen gemäß des unabhängigen Patentanspruchs 10, sowie durch das Verfahren zum Herstellen einer Laser-Dioden-Einheit mit den Merkmalen gemäß des unabhängigen Patentanspruchs 13. Weitere Merkmale und Details der vorliegenden Erfindung ergeben sich aus den Unteransprüchen, der Beschreibung sowie den Zeichnungen. Merkmale und Details, die hinsichtlich eines Vorrichtungsaspekts beschrieben sind, gelten dabei selbstverständlich auch hinsichtlich der jeweils anderen Vorrichtungsaspekte, und umgekehrt, so dass darauf jeweils wechselseitig Bezug genommen wird. Merkmale und Details, die im Zusammenhang mit den erfindungsgemäßen Vorrichtungen beschrieben sind, gelten dabei selbstverständlich auch im Zusammenhang mit dem erfindungsgemäßen Verfahren, so dass alle Merkmale der Vorrichtungsaspekte wechselseitig auch im Zusammenhang mit den anderen Merkmalen der Verfahrensaspekte und umgekehrt gelten, so dass darauf wechselseitig Bezug genommen wird.

Das grundlegende Merkmal der vorliegenden Erfindung, die in den nachfolgend im Detail beschriebenen unterschiedlichen Erfindungsaspekten realisiert ist, besteht insbesondere darin, dass eine horizontale Anordnung von wenigstens zwei in einer Reihe nebeneinander angeordneten Laser-Dioden-Barren dadurch realisiert wird, dass die Laser-Dioden-Barren mittels Klemmung befestigt und fixiert werden. Bisherige horizontale Anordnungen von Laser-Dioden-Barren wurden mittels Lötung realisiert, was zu den eingangs genannten Problemen geführt hat. Diese Nachteile können durch die Klemmbefestigung vermieden werden. Weiterhin ist es gemäß der vorliegenden Erfindung möglich, dass der erforderliche Kühlkreislauf von den Laser-Dioden-Barren elektrisch isoliert und getrennt ist.

Mittels der vorliegenden Erfindung wird es insbesondere möglich, dass ein Ausgleich unterschiedlicher Dicken der horizontal hintereinander angeordneten Laser-Dioden-Barren realisiert werden kann. Dies wird durch das horizontale Klemmen ermöglicht, wie im weiteren Verlauf der Beschreibung in größerem Detail erläutert wird. Gleichzeitig wird es ermöglicht, dass ein gleichmäßiger Druck, insbesondere ein Klemmdruck, auf die einzelnen Laser-Dioden-Barren aufgebracht werden kann. Darüber hinaus können die einzelnen Laser-Dioden-Barren mittels der erfindungsgemäßen Klemmtechnik elektrisch isoliert werden, insbesondere von einem zu verwendenden Kühlkreislauf.

Wie dies im Einzelnen realisiert werden kann, wird nachfolgend anhand vorteilhafter Ausgestaltungen und Ausführungsformen in größerem Detail beschrieben.

Gemäß dem ersten Aspekt der Erfindung wird eine Haltevorrichtung zum horizontalen Befestigen von wenigstens zwei in einer Linie nebeneinander angeordneten Laser-Dioden-Barren bereitgestellt, die dadurch gekennzeichnet ist, dass die Haltevorrichtung zum Klemmbefestigen der Laser-Dioden-Barren ausgebildet ist und wenigstens eine Einrichtung zum Klemmbefestigen der Laser-Dioden-Barren aufweist.

Durch die Haltevorrichtung der vorliegenden Erfindung werden die Laser-Dioden-Barren in einer bestimmten Position gehalten. Die Haltevorrichtung erfüllt dabei den Zweck, dass über diese die Laser-Dioden-Barren in deren Befestigungszustand in einer definierten Position gehalten werden. Dies wird erfindungsgemäß dadurch erreicht, dass die Haltevorrichtung eine Einrichtung zum Klemmbefestigen aufweist, so dass auf die bisher für horizontale Anordnungen erforderliche Lötung verzichtet werden kann. Durch das Klemmen kann, wie im weiteren Verlauf noch näher erläutert wird, auch den unterschiedlichen Dicken der Laser-Dioden-Barren Rechnung getragen werden.

Dabei kann Halten im Sinne der vorliegenden Erfindung auch als Befestigen, Anbinden, Montieren, Anlegen, Aufsetzen oder Anstecken verstanden werden. Die vorliegende Erfindung ist nicht auf bestimmte Arten von Halten beschränkt. Vielmehr wird Halten insbesondere so verstanden, dass eine zeitlich begrenzte oder zeitlich unbegrenzte Fixierung von etwas vorgenommen werden kann beziehungsweise wird. Diese Fixierung kann bei Bedarf gelöst werden, so dass die fixierte oder die gehaltene Komponente nicht mehr gehalten wird, sondern der Haltevorrichtung entnommen werden kann.

Ein Laser-Dioden-Barren ist eine Anordnung mehrerer Laser-Dioden. Dabei ist der Ausdruck Laser-Dioden-Barren in der Lasertechnik ein gängiger Begriff. Mehrere Laser-Dioden sind zu einem Barren zusammengefasst und sind somit mechanisch miteinander verbunden. Mit der Haltvorrichtung kann ein Laser-Dioden-Barren oder mehrere Laser-Dioden-Barren gehalten werden, wobei das Halten insbesondere ein horizontales Halten ist.

Die Haltevorrichtung dient zum Halten von mindestens zwei in einer Linie nebeneinander angeordneten Laser-Dioden-Barren. Die Erfindung ist nicht auf eine bestimmte Anzahl von Laser-Dioden-Barren beschränkt. Das Halten soll dabei horizontal erfolgen, wobei das Halten im Lichte der Erfindung grundsätzlich jedes Halten eines Körpers, insbesondere der Laser-Dioden-Barren im Raum bedeuten kann.

Die vorliegende Erfindung ist nicht auf bestimmte Ausführungsformen beschränkt, wie die Einrichtung zum Klemmbefestigen der Laser-Dioden-Barren ausgestaltet sein muss. Nachfolgend werden hierzu einige vorteilhafte, jedoch nicht ausschließliche Ausführungsbeispiele beschrieben.

Vorzugsweise kann die Einrichtung zum Klemmbefestigen der Laser-Dioden-Barren als Einrichtung zum formschlüssigen und/oder kraftschlüssigen Klemmbefestigen der Laser-Dioden-Barren ausgebildet sein. Eine formschlüssige Verbindung entsteht insbesondere durch das Ineinandergreifen von mindestens zwei Verbindungspartnern. Durch die mechanische Verbindung können sich die Verbindungspartner auch ohne oder bei unterbrochener Kraftübertragung nicht lösen. Kraftschlüssige Verbindungen entstehen beispielsweise durch die Anwendung von Kräften, wie beispielsweise Druckkräften, Reibungskräften und dergleichen.

Vorzugsweise kann die Haltevorrichtung wenigstens zwei Kontaktfahnen zur elektrischen Kontaktierung der Laser-Dioden-Barren aufweisen. Dabei ist insbesondere vorgesehen, dass solche Kontaktfahnen auch als Einrichtung zum Klemmbefestigen der Laser-Dioden-Barren ausgebildet sind oder solche Einrichtungen aufweisen.

Vorzugsweise sind wenigstens zwei Kontaktfahnen vorgesehen. Je nach Ausgestaltung kann die Halteeinrichtung auch mehrere Kontaktfahnen aufweisen. Werden die einzelnen Laser-Dioden-Barren beispielsweise parallel verschaltet, ist es ausreichend, dass die Haltevorrichtung nur zwei Kontaktfahnen aufweist. Werden die einzelnen Laser-Dioden-Barren seriell verschaltet, müssen mehrere Kontaktfahnen zur Anwendung kommen, wobei die Anzahl der Kontaktfahnen dann insbesondere von der Anzahl der Laser-Dioden-Barren abhängt. Die vorliegende Erfindung ist nicht auf eine bestimmte Anzahl von Kontaktfahnen beschränkt.

Mittels der Kontaktfahne(n) kann zum einen ein Dickenausgleich der horizontal nebeneinander angeordneten Laser-Dioden-Barren realisiert werden. Gleichzeitig können die Laser-Dioden-Barren in einer definierten Position gehalten werden. Über die Kontaktfahne(n) wird/werden die Laser-Dioden-Barren elektrisch angeschlossen.

Die Kontaktfahnen können vorzugsweise eine Länge von zwei Laser-Dioden-Barren aufweisen, wobei insbesondere eine Zugabe für die Montageabstände zwischen den einzelnen Laser-Dioden-Barren zugegeben wird.

Als Kontaktfahne zur elektrischen Kontaktierung kann ein elektrisch leitendes Material in jeglicher Form verstanden werden, das auf einen Körper aufgebracht werden kann und womit eine elektrische Verbindung zwischen zwei Körpern hergestellt werden kann. Vorzugweise kann die Kontaktfahne auf einem ersten Körper, der beispielsweise die Haltevorrichtung sein kann, derart aufgebracht werden oder sein, dass ein Teil der Kontaktfahne mit dem Körper unmittelbar, also direkt in Berührung steht. Ein zweiter Teil der Kontaktfahne ist mit dem Körper nicht in Berührung, sondern kann beispielsweise davon abstehen.

Als elektrische Kontaktierung kann insbesondere ein elektrischer Kontakt verstanden werden, der beispielsweise in der Elektrotechnik und Elektronik dazu dient, zwischen Bauelementen, zwischen oder innerhalb von Stromkreisen oder innerhalb von Bauteilen wie Schützen, Relais, Tastern, Schaltern oder dergleichen eine stromleitende Verbindung herzustellen.

Die Kontaktfahnen können auf den beiden Befestigungsbacken oder den Kühlbacken oder den Klemmbacken einer Befestigungsvorrichtung, die weiter unten näher erläutert wird, wechselseitig versetzt angebracht sein, so dass vorzugsweise eine serielle elektrische Beschaltung der Laser-Dioden-Barren erzielt werden kann.

Die Laser-Dioden-Barren werden für die serielle elektrische Beschaltung vorzugsweise mit wechselseitiger Polung montiert. Mit dieser Anordnung kann auf einfache Weise jeweils eine P-Seite des Dioden-Barrens mit der N-Seite des benachbarten Dioden-Barrens mit einer Kontaktfahne elektrisch verbunden werden.

Die äußere elektrische Zuführung, beziehungsweise der äußere elektrische Anschluss kann mechanisch in unterschiedlichen Formen, beispielsweise als Anschlusslasche, Anschlussfahne, Gewinde, Bolzen oder dergleichen ausgebildet sein. Die äußere elektrische Zuführung kann sich an einer der beiden oder an beiden Befestigungsbacken befinden. Bei einer seriellen elektrischen Beschaltung einer geraden Anzahl von montierten Laser-Dioden-Barren, beispielsweise 2, 4, oder 6 und so weiter, befinden sich die beiden äußeren elektrischen Zuführungen an einer Befestigungsbacke. Bei einer ungeraden Anzahl von montierten Laser-Dioden-Barren, beispielsweise 1, 3, 5 und so weiter, befinden sich die beiden äußeren elektrischen Zuführungen an den gegenüberliegenden Befestigungsbacke.

Vorzugsweise kann wenigstens eine Kontaktfahne zumindest bereichsweise aus einem duktilen Material bestehen. Die Kontaktfahne kann dabei vollständig oder nur bereichsweise aus duktilem Material bestehen. Bereichsweise im Lichte der vorliegenden Erfindung wird derart verstanden, dass nur ein Teil der Kontaktfahne aus duktilem Material oder Werkstoff besteht. Die Kontaktfahne kann hierfür aus einem Material oder aber auch aus mehreren Materialien, also aus einer Materialkombination, bestehen. Ebenso ist es möglich, dass die Duktilität des Materials durch eine Behandlung der Kontaktfahne, welche aus einem Material besteht, erzielt wird. Die Behandlung kann dabei thermisch, chemisch oder dergleichen erfolgen. Ebenso ist eine Kombination der oben genannten Möglichkeiten denkbar. Die vorliegende Erfindung ist nicht auf bestimmte Möglichkeiten beziehungsweise Verfahren beschränkt, mit denen oder durch die die Kontaktfahne zumindest bereichsweise die gewünschte Duktilität erhält und/oder aufweist.

Als duktiles Material wird insbesondere ein Material verstanden, das die Eigenschaft besitzt, sich bei äußerem Druck plastisch zu verformen, bevor es versagt. Das duktile Material verformt sich durch Aufbringung eines Drucks oder einer Kraft oder eines Momentes derart, dass eine plastische, also eine dauerhafte Verformung des Materials oder Werkstoffs eintritt und/oder zu beobachten ist und/oder resultiert. Insbesondere kann vorgesehen sein, dass ein oder mehrere Laser-Dioden-Barren sich während des Haltevorgangs in das duktile Material der Kontaktfahne einpressen und auf diese Weise mechanisch positioniert werden.

Beispielsweise kann wenigstens eine Kontaktfahne zumindest bereichsweise aus Kupfermaterial, insbesondere aus weichgeglühtem Kupfermaterial, bestehen. Die Kontaktfahnen dienen zum einen zum Halten, also dem mechanischen Klemmen der Laser-Dioden-Barren mit definierter Anpresskraft und zum anderen der Stromzuführung für die Laser-Dioden-Barren. Die Kontaktfahne kann beziehungsweise die Kontaktfahnen können vorzugweise als weichgeglühtes Kupferband oder Kupferfolie ausgeführt sein. In einer besonderen Ausgestaltung kann die Kontaktfahne als weichgeglühtes Kupferband oder Kupferfolie mit beidseitiger Goldbeschichtung ausgebildet sein.

In weiterer Ausgestaltung kann die Haltevorrichtung wenigstens ein Kühlisolator-Element aufweisen. Ein Kühlisolator-Element ist insbesondere ein Element welches Energie, insbesondere in Form von Wärme, von einem Körper aufnimmt und diese an einen anderen Körper abgibt. Es findet somit ein effizienter Wärmetransport, der vorzugsweise von den Laser-Dioden-Barren zu einem Gegenstück, beispielsweise einer Kühlbacke, einer Klemmbacke oder einer Befestigungsbacke erfolgt, statt. Zudem ist eine weitere Aufgabe des Kühlisolator-Elements das Gegenstück, also beispielsweise die Kühlbacke und damit den Wasserkreislauf elektrisch vom stromführenden Teil der Laser-Dioden-Barren, beispielsweise der Kontaktfahne(n) zu trennen. Auf die genaue Ausgestaltung des Gegenstücks, insbesondere der Kühlbacke, der Klemmbacke, der Befestigungsbacke und des Wasserkreislaufs wird im weiteren Verlauf der Beschreibung explizit eingegangen.

Ein Kühlisolator-Element ist insbesondere mindestens so lang wie ein Laser-Dioden-Barren. Besonders vorzugsweise ist ein Kühlisolator-Element so lang wie zwei Laser-Dioden-Barren, wobei vorzugsweise die Montagabstände zwischen den einzelnen Laser-Dioden-Barren berücksichtigt und hinzugegeben werden. Ein Laser-Dioden-Barren kann beispielsweise 10 mm lang sein. Ein Kühlisolator-Element kann auch dieselbe Länge wie die Summe aller montierten Laser-Dioden-Barren, vorzugsweise zuzüglich aller Montageabstände zwischen den Laser-Dioden-Barren, aufweisen.

Als eine elektrische Isolierung wird eine Isolierung verstanden, die verhindert, dass eine elektrische Verbindung zwischen zwei Körpern beziehungsweise Einheiten derart existiert, dass beispielsweise ein Strom von einem Körper zu einem anderen Körper gelangen oder transportiert werden kann.

Eine Wärmeanbindung im Sinne der vorliegenden Erfindung ist insbesondere eine Anbindung an mindestens einen Körper, so dass Wärme oder Energie von diesem Körper weg transportiert werden kann oder zu diesem hin transportiert werden kann. Es ist aber insbesondere auch vorgesehen, dass die Anbindung zwischen zwei Körpern besteht, so dass Wärme von einem Körper zu dem anderen Körper übertragen wird oder auf den anderen Körper übertragen wird.

Eine Kühlsenke ist insbesondere eine Quelle, die derart ausgestaltet sein kann, dass beispielsweise Wärme von einem Körper zu dieser Kühlsenke transportiert oder übertragen wird, so dass die Temperatur des Körpers reduziert wird beziehungsweise abnimmt. Dabei kann die Kühlsenke derart ausgebildet sein, dass die Temperatur der Kühlsenke durch Aufnahme der Wärme nur sehr geringfügig ansteigt. Dies kann beispielsweise durch ein deutlich größeres Volumen der Kühlsenke im Vergleich zu dem Körper, dessen Temperatur reduziert werden soll, erzielt werden. Die vorliegende Erfindung ist nicht auf bestimmte Arten von Kühlsenken beschränkt.

In einer bevorzugten Ausführungsform ist das Kühlisolator-Element plattenförmig ausgebildet, insbesondere als ein dünnes Plättchen mit geeigneter Abmessung. Eine Patte ist im Lichte der Erfindung insbesondere ein ebenes Bauteil, wobei die Länge und die Breite größere, insbesondere wesentlich größere Zahlenwerte aufweisen, als die Dicke des Bauteils. Das Kühlisolator-Element ist jedoch nicht auf bestimmte Ausführungsformen beschränkt. Das Kühlisolator-Element kann in jeder denkbaren Form ausgestaltet sein.

In einer weiteren bevorzugten Ausführungsform weist das Kühlisolator-Element eine Dicke von 50 µm bis 1000 µm auf, wobei das Kühlisolator-Element nicht auf diese Dicken beschränkt ist. So kann das Kühlisolator-Element ebenfalls Dicken kleiner als 50 µm oder größer als 1000 µm aufweisen. Als Dicke wird die im Vergleich zur Länge und Breite des Kühlisolator-Elements erforderliche dritte Ausrichtung des Körpers im Raum verstanden. Die Dicke kann auch als Tiefe bezeichnet werden.

Das Kühlisolator-Element kann aus jedem Material bestehen. Das Kühlisolator-Element kann bevorzugt aus synthetischem Diamant gebildet sein.

In einer weiteren bevorzugten Ausführungsform weist das Kühlisolator-Element eine Wärmeleitfähigkeit von größer 1000 W/mK auf. Insbesondere weist das Kühlisolator-Element eine Wärmeleitfähigkeit von etwa 1800 W/mK auf.

Aufgrund einer sehr guten Wärmeleitfähigkeit bei Verwendung von synthetischem Diamant, welcher mit ungefähr 1800 /mK im Vergleich zu Kupfer, welches ein Wärmleitfähigkeit von ungefähr 400 W/mK aufweist, eine deutlich höhere Wärmeleitfähigkeit besitzt, ist das Kühlisolator-Element in einer bevorzugten Ausführungsform als Wärme-Spreizungs-Element ausgebildet. Das Kühlisolator-Element führt also zu einer "Wärme-Spreizung", wodurch die Kühleffizienz der Kühlbacke oder der Befestigungsbacke wesentlich gesteigert ist. Eine "Wärme-Spreizung" ist dabei ein bekannter Begriff der Thermodynamik und umfasst, dass ein Wärmestrom von einem Bauteil in ein anderes Bauteil übergeht, wobei der Wärmestrom beispielsweise von einer kleinen Fläche des ersten Bauteils auf eine dazu größere Fläche des zweiten Bauteils aufgeteilt oder gespreizt werden kann.

Vorzugsweise kann auf wenigstens ein Kühlisolator-Element, beispielsweise auf die beiden Kühlisolator-Elemente, wenigstens eine -insbesondere duktile metallische - Kontaktfahne aufgebracht sein oder angebracht werden.

Vorzugsweise kann die wenigstens eine Kontaktfahne an dem wenigstens einen Kühlisolator-Element angeordnet oder ausgebildet sein. Dadurch kann insbesondere eine kühltechnische und eine elektrische Trennung realisiert werden. Es ist aber auch möglich, dass jeweils eine Kontaktfahne an mehreren Kühlisolator-Elementen angeordnet oder ausgebildet ist oder wird. Weiterhin ist möglich, dass mehrere Kontaktfahnen an einem oder mehreren Kühlisolator-Element(en) angeordnet oder ausgebildet sind. Es ist aber insbesondere auch möglich, dass die Kontaktfahne direkt auf das Kühlisolator-Element aufgebracht ist oder wird. Das Aufbringen ist dabei beispielsweise durch chemische Metallisierung, Sputtern oder dergleichen möglich. Das Aufbringen ist nicht auf bestimmte Verfahren des Aufbringens beschränkt. Ebenso ist denkbar, dass zwischen der Kontaktfahne und dem Kühlisolator-Element eine oder mehrere Zwischenschichten eingebracht sind beziehungsweise werden. In diesem Fall existiert kein unmittelbarer Kontakt zwischen Kontaktfahne und Kühlisolator-Element.

Gemäß einem zweiten Aspekt der vorliegenden Erfindung wird eine Befestigungsvorrichtung zum horizontalen Befestigen von wenigstens zwei in einer Linie nebeneinander angeordneten Laser-Dioden-Barren bereitgestellt, die dadurch gekennzeichnet ist, dass diese zum Klemmbefestigen der Laser-Dioden-Barren ausgebildet ist.

Als klemmbefestigt wird im Sinne der vorliegenden Erfindung insbesondere verstanden, dass ein Körper, insbesondere ein oder mehrere Laser-Dioden-Barren sowohl temporär wie auch dauerhaft geklemmt oder befestigt oder fixiert werden kann beziehungsweise. können. Es handelt sich also bei einer Klemmbefestigung insbesondere um eine im Bedarfsfalle lösbare d.h. wahlweise temporär oder dauerhaft wirkende Befestigung. Des Weiteren wird auf die vorstehenden Ausführungen zur Klemmbefestigung im Zusammenhang mit der erfindungsgemäßen Haltevorrichtung vollinhaltlich Bezug genommen und verwiesen.

Vorzugsweise kann die Befestigungsvorrichtung wenigstens eine wie vorstehend beschriebene erfindungsgemäße Haltevorrichtung aufweisen, so dass hinsichtlich der Merkmale und Details der Haltevorrichtung auf die vorstehenden Ausführungen vollinhaltlich Bezug genommen und verwiesen wird.

Vorzugsweise kann die Befestigungsvorrichtung wenigstens eine, vorzugsweise zwei Befestigungsbacken aufweisen. Bevorzugt ist vorgesehen, dass jede Befestigungsbacke auch über eine dieser zugeordneten Haltevorrichtung verfügt.

Erfindungsgemäß handelt es sich bei der Befestigungsvorrichtung um eine Befestigungsvorrichtung zum horizontalen Befestigen mehrerer Laser-Dioden-Barren, insbesondere mit einer oder mehrerer Befestigungsbacken. Dabei ist die vorliegende Erfindung nicht auf eine bestimmte Anzahl von Laser-Dioden-Barren und/oder Befestigungsbacken beschränkt. Die Befestigung kann dabei mit einer oder mit mehreren Befestigungsbacken erfolgen. Insbesondere erfolgt die Befestigung mit zwei Befestigungsbacken.

Eine Befestigungsbacke im Sinne der vorliegenden Erfindung ist insbesondere eine Befestigungsbacke, welche eine Haltevorrichtung mit den oben genannten Merkmalen beinhaltet. Die Befestigungsbacke kann somit beispielsweise wenigstens ein Kühlisolator-Element und/oder wenigstens eine Kontaktfahne aufweisen. Die Befestigungsbacke kann somit insbesondere eine Backe sein, mit der mehrere Laser-Dioden-Barren, die horizontal in einer Linie nebeneinander angeordnet sind, befestigt werden können. Eine Befestigungsbacke kann auf verschiedene Art und Weise ausgebildet sein, beispielsweise als Kühlbacke und/oder Klemmbacke. In einem solchen Fall weist eine Befestigungsbacke das entsprechende Merkmal der entsprechenden Backe auf, also ein Merkmal zum Kühlen oder zum Klemmen. Es ist aber auch möglich, dass eine Befestigungsbacke eine Kombination aus Kühlbacke und Klemmbacke darstellt. In einem solchen Fall ist die Befestigungsbacke gleichzeitig eine Kühlbacke und eine Klemmbacke. Sofern die Kühlung gemeint ist, wird in der vorliegenden Erfindung eine Kühlbacke verwendet, wobei eine Befestigungsbacke nicht ausgeschlossen wird. Vielmehr wird durch Verwendung des Begriffs Kühlbacke verdeutlich, dass das Merkmal der Kühlung eine weitere wesentliche Rolle spielt. Da eine Befestigungsbacke auch eine Kühlbacke umfassen kann, wird bei der Verwendung des Begriffs Kühlbacke immerzu eine Befestigungsbacke mitgelesen oder ist damit gemeint. Entsprechendes gilt für die Verwendung des Begriffs Klemmbacke, da eine Befestigungsbacke auch die Funktion einer Klemmbacke umfassen kann. Deswegen wird bei der Verwendung des Begriffs Klemmbacke ebenfalls stets eine Befestigungsbacke mitgelesen oder ist damit gemeint.

In einer weiteren Ausführungsform weist die Befestigungsvorrichtung wenigstens eine Befestigungsbacke auf, die eine Kühleinrichtung aufweist. Hierbei handelt es sich dann um eine wie oben beschriebene Kühlbacke. Die Kühleinrichtung kann dabei mit einem Kühlmedium flüssigkeitsgekühlt werden. Das Kühlmedium kann dabei insbesondere Wasser oder ein spezielles Kühlfluid sein, wobei die Erfindung nicht auf bestimmte Kühlmedien limitiert ist.

Die Kühleinrichtung hat vorzugsweise mindestens einen Flüssigkeitszulauf und mindestens einen Flüssigkeitsablauf, wobei die Kühleinrichtung nicht auf eine bestimmte Anzahl von Zu- oder Abläufe beschränkt ist. Es können auch mehrere Flüssigkeitszuläufe und/oder -abläufe vorhanden sein. Vorzugsweise weist die Kühleinrichtung einen Korpus auf. Der Korpus dient insbesondere der definierten Kühlwasserführung.

Das Material der Befestigungsbacke(n) kann sowohl metallisch wie auch nichtmetallisch sein. Vorzugsweise ist die Befestigungsbacke aus Kupfer, Kupferlegierungen oder Aluminium als metallisches Material oder aus AIN, BeO oder Diamant als nichtmetallisches Material gefertigt, beziehungsweise hergestellt. Die vorliegende Erfindung ist nicht auf bestimmte Materialien für die Befestigungsbacke beschränkt.

Die Befestigungsbacke kann mechanisch und/oder im Sinterverfahren und /oder im Gussverfahren hergestellt werden. Als mechanisches Herstellverfahren kann insbesondere Drehen und/oder Fräsen und /oder Bohren und/oder Hohnen und/oder Läppen verwendet werden. Als Sinterverfahren kann insbesondere Lasersintern verwendet werden. Als Gießverfahren kann insbesondere Metallguss verwendet werden. Die vorliegende Erfindung ist jedoch nicht auf diese Herstellverfahren für die Befestigungsbacke beschränkt.

Ebenso ist es möglich, dass eine Befestigungsbacke mehr als eine Kühleinrichtung aufweist.

Weiterhin kann eine Kühleinrichtung in unterschiedlichen Bauformen realisiert werden. Vorzugsweise kann eine Kühleinrichtung als Mikrokanalkühler in Metallbauweise, insbesondere aus Kupfer, und/oder als Kühler in Metall-Sinterbauweise und/oder als Mikrokanalkühler in Keramik-Bauweise und/oder als PIN-FIN-Kühler in Metall- oder Keramik-Bauweise und/oder als konventionell gefertigte Kühler in Metall- oder Keramik-Bauweise hergestellt werden.

In einer weiteren Ausführungsform weist wenigstens eine Befestigungsbacke eine Wärmeaustauschfläche auf. Eine Wärmeaustauschfläche stellt insbesondere den äußeren Kontakt zum zu kühlenden Bauteil dar. In einer vorzugsweisen Bauform kann die Wärmeaustauschfläche als PIN-FIN-Kühler oder als Mikrokanalkühler ausgelegt sein.

Weiterhin kann auf die Wärmeaustauschfläche, welche Bestandteil der Befestigungsbacke sein kann, das Kühlisolator-Element aufgebracht sein. In diesem Fall kann die Wärmeaustauschfläche zunächst eine Hochpräzisionsbearbeitung erhalten, so dass eine sehr ebene Auflagefläche geschaffen wird. Diese Hochpräzisionsbearbeitung kann insbesondere Diamantfräsen und/oder Läppen sein.

Die Wärmeaustauschfläche kann nach einem der oben genannten Herstellverfahren hergestellt sein. Es ist aber auch möglich, dass die Wärmeaustauschfläche durch Prägen, insbesondere durch Mikroprägen hergestellt wird beziehungsweise ist. Die vorliegende Erfindung ist nicht auf bestimmte Herstellverfahren beschränkt.

In einer weiteren Ausführungsform ist die Befestigungsvorrichtung derart ausgestaltet, dass die Wärmeaustauschfläche eine Kühleinrichtung aufweist oder als Kühleinrichtung ausgebildet ist. Vorzugsweise wird/werden hierbei ein/mehrere

Kühlisolator-Element/e ausschließlich durch Klemmen mittels Reib- und/oder Formschluss auf der Wärmeaustauschfläche befestigt. In einer weiteren Ausgestaltung kann/können ein oder mehrere Kühlisolator-Element/-e zusätzlich auf der Wärmeaustauschfläche fixiert werden. Dies kann beispielsweise mittels Klebung erfolgen. Hierzu können auf eine Wärmeaustauschfläche Taschen für die Aufnahme des Klebstoffes eingebracht werden. Alternativ können die Kühlisolator-Elemente auf den Kühlbacken mittels Löten oder einer sonstigen dauerhaft oder temporär wirkenden Verbindungstechnik befestigt werden.

Eine weitere Möglichkeit die Kühlleistung der Kühleinrichtung zu verbessern besteht insbesondere darin, ein Kühlisolator-Element nicht auf eine Wärmeaustauschfläche zu pressen, sondern das Kühlisolator-Element in direkten Kontakt mit dem Kühlmedium zu bringen. Dazu kann vorzugsweise die Rückseite des Kühlisolators-Elements von dem Kühlmedium umspült werden. Das Kühlisolator-Element könnte hierfür in eine entsprechende Öffnung der Wärmeaustauschfläche oder auch direkt in die Kühlbacke und/oder die Kühleinrichtung eingelassen werden. Vorzugsweise verschließt das Kühlisolator-Element dabei die Öffnung in der Wärmeaustauschfläche oder der Kühlbacke oder der Kühleinrichtung. Die Ränder des Kühlisolator-Elements können hierfür dicht mit der Wärmeaustauschfläche oder der Kühlbacke oder der Kühleinrichtung verbunden sein oder werden. Diese Verbindung kann insbesondere durch Kleben, Löten oder eine umlaufende Dichtung realisiert werden.

In einer weiteren Ausführungsform ist vorgesehen, dass auf einer Befestigungsbacke ein Kühlisolator-Element der Haltevorrichtung angeordnet sein kann. Ebenso ist vorgesehen, dass auf einer Wärmeaustauschfläche ein Kühlisolator-Element der Haltevorrichtung angeordnet sein kann. Ebenso ist es möglich, dass ein Kühlisolator-Element der Haltevorrichtung sowohl auf einer Befestigungsbacke als auch auf einer Wärmeaustauschfläche angeordnet sein kann. Ebenfalls vorgesehen ist, dass mehr als eine Befestigungsbacke mit einem Kühlisolator-Elements der Haltevorrichtung versehen wird oder ist.

In einer weiteren Ausführungsform ist vorgesehen, dass die Befestigungsvorrichtung ein Trägerelement aufweist, an dem eine Befestigungsbacke angeordnet ist. Dabei kann auch mehr als eine Befestigungsbacke an dem Trägerelement angeordnet sein. Vorzugsweise sind auf dem Trägerelement zwei Befestigungsbacken montiert. Wie bereits oben erwähnt, kann eine Befestigungsbacke die Funktion einer Klemmbacke und/oder einer Kühlbacke oder eine Kombination dieser beiden Backen umfassen.

Zur Montage eines Laser-Dioden-Barrens kann ein Multi-Element-Paket "Befestigungsbacke, beispielsweise Kühlbacke - Kühlisolator-Element-Kontaktfahne - Laser-Dioden-Barren - Kontaktfahne - Kühlisolator-Element-Befestigungsbacke, beispielsweise Kühlbacke" auf ein Trägerelement, welches auch als Montageträger bezeichnet werden kann, montiert werden. Dieses Trägerelement kann somit zum einen der mechanischen Befestigung der beiden außen liegenden Befestigungsbacken dienen und kann das mechanische Verpressen des kompletten Paketes erlauben.

Das Trägerelement, also der Montageträger kann weiterhin der Kühlwasser-Zuführung, Kühlwasser-Abführung und Kühlwasser-Verteilung auf die beiden Befestigungsbacken dienen.

In einer weiteren Ausführungsform weist der Montageträger eine Anpressvorrichtung zum Aufbringen eines definierten Pressdrucks auf die wenigstens eine Befestigungsbacke auf. Dabei kann der Pressdruck auch auf mehrere, vorzugsweise auf zwei Befestigungsbacken aufgebracht werden.

Durch das oben genannte Trägerelement wird ein definierter Anpressdruck auf das Multi-Element-Paket ermöglicht. Dies kann mit der zusätzlichen Anpressvorrichtung und/oder durch eine externe Anpressvorrichtung, insbesondere temporär, erfolgen.

Als zusätzliche Anpressvorrichtung können insbesondere Schrauben, in Form als Anpressschrauben verwendet werden. Die externe Anpressvorrichtung kann vornehmlich während des Montagevorganges verwendet werden und nach diesem von der Befestigungsvorrichtung entfernt werden.

Gemäß einem weiteren Aspekt der vorliegenden Erfindung wird eine Laser-Dioden-Einheit mit wenigstens zwei horizontal in einer Linie nebeneinander angeordneten Laser-Dioden-Barren und einer Haltevorrichtung oder einer Befestigungsvorrichtung bereitgestellt. Dabei ist vorgesehen, dass die Haltevorrichtung einer wie oben beschriebenen Haltevorrichtung entspricht. Die Befestigungsvorrichtung kann dabei einer Befestigungsvorrichtung, wie sie bereits weiter oben beschrieben wurde, entsprechen. Aus diesem Grund wird zur Vermeidung von Wiederholungen auf die vorstehenden Ausführungen zur erfindungsgemäßen Haltevorrichtung und zur erfindungsgemäßen Befestigungsvorrichtung vollinhaltlich Bezug genommen und verwiesen.

Vorzugsweise weist die Befestigungsvorrichtung zwei Befestigungsbacken auf, an denen jeweils eine Haltevorrichtung vorgesehen ist, wobei die Laser-Dioden-Barren zwischen den Haltevorrichtungen der zwei Befestigungsbacken, insbesondere zwischen den Kontaktfahnen der Haltevorrichtungen, eingeklemmt sind.

Dabei sind die Laser-Dioden-Barren mittels Klemmverbindung an/in der Haltevorrichtung oder der Befestigungsvorrichtung angeordnet

In einer weiteren Ausführungsform sind auf beiden Seiten der Laser-Dioden-Barren jeweils wenigstens ein Kühlisolator-Element und jeweils wenigstens eine Kontaktfahne vorgesehen.

Vorzugsweise können die Laser-Dioden-Barren über die beidseitig angeordneten mindestens zwei Kontaktfahnen der Haltevorrichtung elektrisch seriell oder parallel verschaltet sein.

In einer weiteren Ausführungsform ist vorgesehen, dass mehrere Laser-Dioden-Barren vorgesehen sind, die mit wechselseitiger Polung in der Laser-Dioden-Einheit angeordnet sind.

Die äußeren elektrischen Zuführungen können sich an einer der beiden oder an beiden Befestigungsbacken befinden. Bei einer geraden Anzahl von montierten Laser-Dioden-Barren, beispielsweise 2, 4 oder 6 und so weiter, befinden sich beiden äußeren elektrischen Zuführungen an einer Befestigungsbacke Bei einer ungeraden Anzahl von montierten Laser-Dioden-Barren, beispielsweise 1, 3 oder 5 und so weiter, befinden sich die äußeren elektrischen Zuführungen an beiden Befestigungsbacken.

Vorzugsweise kann zwischen den Haltevorrichtungen der beiden Befestigungsbacken weiterhin wenigstens ein Abstandhalterelement vorgesehen sein.

Damit die Laser-Dioden-Barren das Licht in definierter Weise abstrahlen können, und damit eine optimale, gleichmäßige Kühlung der Laser-Dioden-Barren erreicht werden kann, ist es insbesondere erforderlich, dass die Laser-Dioden-Barren bündig am oberen Ende der Haltevorrichtung und/oder der Befestigungsvorrichtung abschließen. Insbesondere gilt es zu verhindern, dass die Laser-Dioden-Barren schief eingeklemmt werden, oder das die die Klemmung bewirkenden Bauteile schief an den Laser-Dioden-Barren anliegen. Durch die Verwendung von wenigstens einem Abstandhalterelement, das auch als Spacer-Element bezeichnet werden kann, kann erreicht werden, dass die Laser-Dioden-Barren stets bündig und gerade geklemmt werden. Das wenigstens eine Abstandhalterelement dient dabei als eine Art Gegenlager.

Dabei ist die Erfindung nicht auf eine bestimmte Anzahl oder eine bestimmte Ausgestaltung des wenigstens einen Abstandhalterelements beschränkt. Bevorzugt ist das Abstandhalterelement oder sind die Abstandhalterelemente in einer Weise ausgebildet, dass diese(s) die gleiche Höhe beziehungsweise Dicke wie der/die Laser-Dioden-Barren aufweist, so dass diese gerade angedrückt werden können.

Der/die Abstandshalter sind vorzugsweise aus elektrisch isolierendem Material vorzugsweise aus Kunststoff oder Keramik hergestellt. Es können beispielsweise Fäden geeigneter Dicke wie beispielsweise Nylonfäden eingesetzt werden. Auch können streifen- und/oder plattenförmige Abstandhalter beispielsweise aus Silikon verwendet werden.

Gemäß eines weiteren Aspekts der vorliegenden Erfindung wird ein Verfahren zum Herstellen einer Laser-Dioden-Einheit, insbesondere einer wie vorstehend beschriebenen erfindungsgemäßen Laser-Dioden-Einheit, bereitgestellt wobei die Laser-Dioden-Einheit wenigstens zwei horizontal in einer Linie nebeneinander angeordnete Laser-Dioden-Barren aufweist, und wobei die Laser-Dioden-Barren mittels einer Befestigungsvorrichtung, insbesondere mit wenigstens einer, vorzugsweise zwei Befestigungsbacken befestigt werden. Das Verfahren ist dadurch gekennzeichnet, dass die Laser-Dioden-Barren durch Klemmen horizontal an/in der Befestigungsvorrichtung (2) fixiert werden. Hinsichtlich des Klemmvorgangs und dessen funktionsweise wird zur Vermeidung von Wiederholungen auch auf die vorstehenden Ausführungen zu den anderen Erfindungsaspekten vollinhaltlich Bezug genommen und verwiesen.

In einer weiteren Ausführungsform weist die Befestigungsvorrichtung zwei Befestigungsbacken auf, wobei jede Befestigungsbacke eine Haltevorrichtung mit wenigstens einer Kontaktfahne zur elektrischen Kontaktierung der Laser-Dioden-Barren aufweist, und wobei die wenigstens eine Kontaktfahne zumindest bereichsweise aus einem duktilen Material besteht. Dabei werden die Laser-Dioden-Barren in das duktile Material der Kontaktfahne(n) eingepresst.

In einer weiteren Ausführungsform können die Laser-Dioden-Barren mit ihren Austrittsfacetten auf eine Auflageplatte aufgelegt und auf der Auflageplatte horizontal derart ausgerichtet werden, dass die eine Befestigungsbacke der Befestigungsvorrichtung über den Laser-Dioden-Barren positioniert werden kann, so dass anschließend die Laser-Dioden-Barren durch Klemmen an/in der Befestigungsvorrichtung fixiert werden.

Zur Montage der Laser-Dioden-Barren müssen diese relativ zu den Befestigungsbacken, die auch als Klemmbacken bezeichnet werden können, horizontal mit hoher Präzision angeordnet werden. Dabei ist vorzugsweise vorgesehen die Laser-Dioden-Barren mit ihrer Austrittsfacette auf die Auflageplatte, welche insbesondere eine geeignete Auflageplatte ist, aufgelegt werden und die Befestigungsbacken über die Laser-Dioden-Barren positioniert werden. Die Auflageplatte sollte dabei keine Beschädigung der äußerst empfindlichen Austrittsfacetten hervorrufen. Die Auflageplatte kann beispielsweise eine Metallplatte zum Beispiel eine polierte Edelstahlplatte oder eine Glasplatte sein.

Zur exakten horizontalen Ausrichtung kann die Auflageplatte mit zusätzlichen Positionierelementen versehen sein. Dies können insbesondere Markierungen auf der Auflageplatte oder geeignete Anschläge sein. Zur exakten horizontalen Ausrichtung können auch externe Positioniervorrichtungen zum Einsatz kommen. Diese können von Hand oder automatisiert verwendet werden.

Die Laser-Dioden-Barren können beispielsweise mit Hilfe einer Vakuumvorrichtung, die in die Auflageplatte integriert sein kann, während der Montage in ihrer Position fixiert werden. Dabei ist die exakte relative und/oder absolute Ausrichtung der Laser-Dioden-Barren auf der Auflageplatte wichtig. Insbesondere sollte die horizontale Ausrichtung besser als 5 µm sein.

Die Abstände der einzelnen Laser-Dioden sollten mit einer Genauigkeit von besser als 100 µm vorgenommen werden.

Insbesondere sollte erreicht werden, dass die relative Ausrichtung der Facetten mit einer Genauigkeit von besser als 5 µm erfolgt. Dies kann beispielsweise durch das Auflegen der Facetten auf die Auflageplatte erreicht werden.

Die endgültige horizontale Ausrichtung kann mit Hilfe der Befestigungsbacken erfolgen.

Insbesondere können die Laser-Dioden-Barren durch Klemmen zwischen zwei Befestigungsbacken fixiert werden. Hierbei wird ausgenutzt, dass es - abhängig von der Druckbeaufschlagung durch die beiden Kühlbacken - zu einem Verformen der beiden duktilen Kontaktfahnen kommt. Jeder einzelne Laser-Dioden-Barren kann dabei in das leicht verformbare Metall der Kontaktfahnen hineingedrückt werden. Die äußere Form jedes einzelnen Laser-Dioden-Barrens wird in das Metall der Kontaktfahne "eingeprägt". Somit kommt es neben einem "Reibschluss" zwischen dem Laser-Dioden-Barren und dem Metall der Kontaktfahne zusätzlich zu einem "Formschluss" zwischen den beiden Elementen.

Bei einer nachfolgenden alternierenden Strom-Beaufschlagung der Laser-Dioden-Barren kann es zu einem Ausdehnen, sofern der Laser-Dioden-Barren bestromt wird, oder zu einem Zusammenziehen, sofern der Laser-Dioden-Barren nicht bestromt wird, des Laser-Dioden-Barrens kommen. Dieser Effekt kann gezielt ausgenutzt werden, um eine zusätzliche Kontaktverbesserung zwischen der Goldauflage der Laser-Dioden-Barren und der Metalloberfläche der Kontaktfahnen hervorzurufen.

Ein weiterer Vorteil dieser Verbindungstechnik liegt darin, dass zur Befestigung und Kühlung der Laser-Dioden-Barren keine Lötverbindung verwendet werden muss. Lötverbindungen sind immer problematisch, da durch unterschiedliche thermische Ausdehnungskoeffizienten der beteiligten Fügepartner häufig innere Spannungen in das Halbleitermaterial der Laser-Dioden-Barren eingebracht werden, was zu einer verminderten Lebensdauer der Laser-Dioden-Barren führt.

Insbesondere im Pulsbetrieb, bei dem sich in ständigen Intervallen der Laser-Dioden-Barren ausdehnt und wieder zusammenzieht, kann es zu einer Ermüdung der Lötverbindung mit anschließendem Versagen kommen.

Ein weiterer Vorteil der erfindungsgemäßen Klemmtechnik liegt in der Tatsache, dass die Laser-Dioden-Barren von der wasserdurchströmten Kühlbacke elektrisch isoliert sind. Dies erlaubt zum einen die Verwendung nicht-entionisierten Wassers und damit den Einsatz kostengünstigerer Kühlsysteme.

Zum weiteren wird die Korrosion im kompletten Lasersystem mit allen seinen Elementen reduziert, da das Kühlwasser nicht Bestandteil des elektrischen Stromkreises ist.

Die Klemmung der Laserdioden kann beispielsweise allein oder durch Kombination nur über die Befestigungsflächen und/oder durch außenseitig angebrachte Drück-Schrauben und/oder durch anderweitige Andrück-Mechanismen und/oder durch innenseitig angebrachte Zug-Schrauben und/oder durch anderweitige Zug-Mechanismen erfolgen.

Die vorliegende Erfindung betrifft insbesondere eine Haltevorrichtung zum horizontalen Befestigen von mindestens zwei in einer Linie nebeneinander angeordneten Laser-Dioden-Barren, wobei die Haltevorrichtung wenigstens ein Kühlisolator-Element für eine elektrische Isolierung und für eine Wärmeanbindung zu einer Kühlsenke in einer ersten Ausführungsform und/oder wenigstens eine Einrichtung zum Klemmbefestigen, insbesondere eine Kontaktfahne aus duktilem Material, zur elektrischen Kontaktierung der Laser-Dioden-Barrens in einer zweiten Ausführungsform aufweist. Ferner betrifft die vorliegende Erfindung eine Befestigungsvorrichtung zum horizontalen Befestigen von wenigstens zwei in einer Linie nebeneinander angeordneten Laser-Dioden-Barren, wobei die Befestigungsvorrichtung eine entsprechende Haltevorrichtung umfasst. Darüber hinaus umfasst die vorliegende Erfindung eine Laser-Dioden-Einheit mit entsprechend angeordneten Laser-Dioden-Barren, die eine entsprechende Haltevorrichtung oder eine entsprechende Befestigungsvorrichtung aufweist, sowie ein Verfahren zum Herstellen einer solchen Laser-Dioden-Einheit.

Die Erfindung wird nachfolgend anhand von Ausführungsbeispielen unter Bezugnahme auf die beiliegenden Zeichnungen in größerem Detail beschrieben. Es zeigen
- Figur 1: eine Explosionsdarstellung einer erfindungsgemäßen Laser-Dioden-Einheit;
- Figur 2: ein Ausführungsbeispiel mit einer seriellen Verschaltung der einzelnen Laser-Dioden-Barren; und
- Figur 3: ein Ausführungsbeispiel mit einer parallelen Verschaltung der einzelnen Laser-Dioden-Barren.

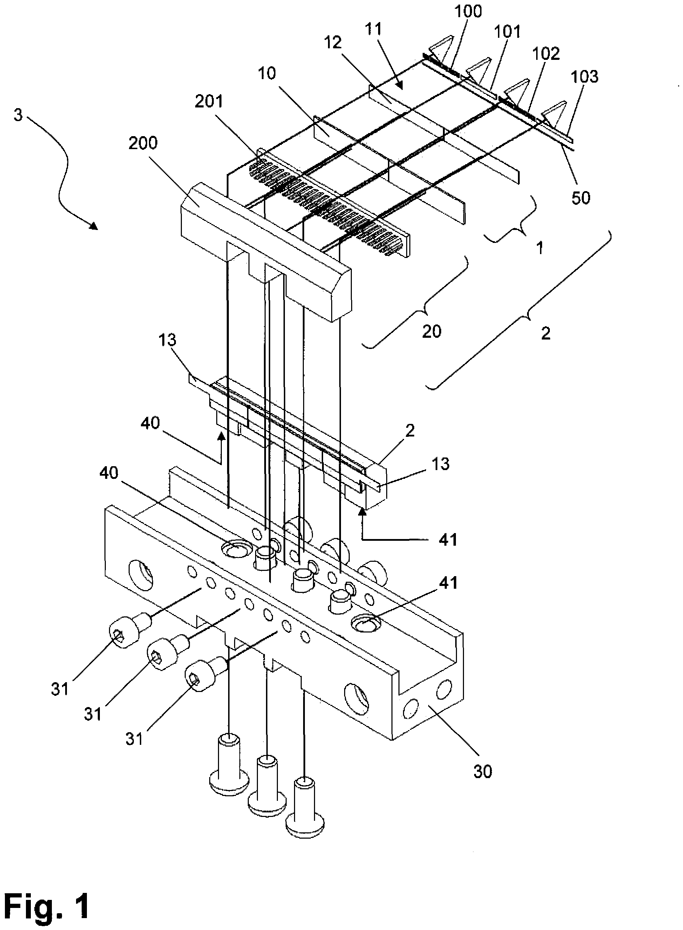

Gemäß Figur 1 sind auf einem Trägerelement 30 zwei Befestigungsbacken 20, die auch als Kühlbacken und/oder Klemmbacken bezeichnet werden können, montiert. Die Befestigungsbacken 20 sind Bestandteil einer Befestigungsvorrichtung 2 zur horizontalen Befestigung von in einer Reihe nebeneinander angeordneten Laser-Dioden-Barren 100, 101, 102, 103. Die Befestigungsbacken 20 sind mit einem Kühlmedium flüssigkeitsgekühlt und haben dazu mindestens einen Flüssigkeitszulauf 40 und mindestens einen Flüssigkeitsablauf 41. Es können auch mehrere Flüssigkeitszuläufe und/oder -abläufe vorhanden sein. Als Kühlmedium kann Wasser oder ein spezielles Kühlfluid verwendet werden.

Die Befestigungsbacken 20 bestehen jeweils aus einem Korpus 200 und einer Wärmeaustauschfläche 201. Der Korpus 200 dient der definierten Kühlwasserführung und die Wärmeaustauschfläche 201 stellt den äußeren Kontakt zum zu kühlenden Bauteil dar.

In einer speziellen Bauform kann die Wärmeaustauschfläche 201 als PIN-FIN-Kühler oder als Mikrokanalkühler ausgelegt sein. Das Material des Korpus 200 der Befestigungsbacken 20 kann sowohl metallisch aus beispielsweise Kupfer, Kupferlegierungen oder Aluminium als auch nichtmetallisch aus beispielsweise AIN, BeO oder Diamant gefertigt sein.

Der Korpus 200 der Befestigungsbacke 20 kann mechanisch durch beispielsweise Drehen und/oder Fräsen und/oder Bohren und/oder Hohnen und /oder Läppen und/oder im Sinterverfahren durch beispielsweise Lasersintern und /oder im Gussverfahren durch beispielsweis Metallguss hergestellt werden.

Die Wärmeaustauschfläche 201, die eine Wärmeaustauschplatte sein kann, kann nach gleichen Verfahren hergestellt werden und durch Umformverfahren wie beispielsweise Prägen beziehungsweise Mikroprägen hergestellt werden. Auf die Wärmeaustauschfläche 201 der beiden Befestigungsbacken 20 werden Kühlisolator-Elemente 10 aufgebracht. Die Kühlisolator-Elemente 10 sind Bestandteil einer Haltevorrichtung 1 zum Halten von Laser-Dioden-Barren 100, 101, 102, 103. Hierzu erhält die Wärmeaustauschfläche 201 zunächst eine Hochpräzisions-Bearbeitung beispielsweise Diamantfräsen und/oder Läppen mit dem Ziel, eine sehr ebene Auflagefläche zu erhalten.

Die Aufgabe der Kühlisolator-Elemente 10 besteht darin, die Befestigungsbacke 20 und gegebenenfalls auch den Wasserkreislauf elektrisch vom stromführenden Teil der Laser-Dioden-Barren 100, 101, 102, 103 zu trennen.

Zum weiteren dient das Kühlisolator-Element 10 dazu, dass ein sehr effizienter Wärmetransport von den Laser-Dioden-Barren 100, 101, 102, 103 zur Befestigungsbacke 20 erfolgt. Eine geeignete Ausführungsform des Kühlisolator-Elements 10 ist ein dünnes Diamant-Plättchen geeigneter Abmessung. Dabei ist das Diamant-Plättchen vorzugsweise als synthetisch hergestelltes Diamant-Plättchen ausgebildet. Die Dicke des Diamant-Plättchens sollte im Bereich von 50 µm bis 1000 µm liegen. Aufgrund der sehr guten Wärmeleitfähigkeit von synthetischem Diamant, die circa 1800 W/mK beträgt, im Vergleich zu Kupfer, die circa 400 W/mK beträgt, führt das Kühlisolator-Element 10 zu einer "Wärme-Spreizung" wodurch die KühlEffizienz der Befestigungsbacke 20 wesentlich gesteigert wird.

Auf die beiden Kühlisolator-Elemente 10 werden duktile metallische Kontaktfahnen 12 aufgebracht. Die Kontaktfahnen 12 sind Bestandteil einer Haltevorrichtung 1 zum Halten der Laser-Dioden-Barren 100, 101, 102, 103. Bei den Kontaktfahnen 12 handelt es sich um eine bevorzugte Ausführungsform einer Einrichtung 11 zum Klemmbefestigen der Laser-Dioden-Barren 100, 101, 192, 103. Die Kontaktfahnen 12 dienen zum einen dem mechanischen Klemmen der Laser-Dioden-Barren 100, 101, 102, 103 mit einer definierten Anpresskraft und zum anderen der Stromzuführung für die Laser-Dioden-Barren 100, 101, 102, 103. Die Kontaktfahnen 12 können vorzugweise als weichgeglühtes Kupferband - vorzugsweise mit beidseitiger Goldbeschichtung - ausgeführt sein. Alternativ kann die Kontaktfahne 12 auch direkt auf den Kühlisolator-Element 10 aufgebracht sein. Dies kann beispielsweise durch chemische Metallisierung und/oder Sputtern erfolgen. Die Kontaktfahnen 12 stehen mit äußeren elektrischen Zuführungen 13 in Verbindung beziehungsweise können über solche Zuführungen verfügen.

Der Korpus 200, die Wärmeaustauschfläche 201, das Kühlisolator-Element 10 und die Kontaktfahne 12 bilden zusammen eine Befestigungsvorrichtung 2.

Zur Montage der Laser-Dioden-Barren 100, 101, 102, 103 wird das Multi-Element-Paket "Befestigungsbacke 20 - Kühlisolator-Element 10 - Kontaktfahne 12 - Laser-Dioden-Barren 100, 101, 102, 103 - Kontaktfahne 12 - Kühlisolator-Element 10-Befestigungsbacke 20" auf das Trägerelement 30 montiert. Dieses Trägerelement 30 dient zum einen der mechanischen Befestigung der beiden außen liegenden Befestigungsbacken 20 und erlaubt das mechanische Verpressen des kompletten Paketes.

Zwei Befestigungsvorrichtungen 2, das Trägerelement 30 und die Laser-Dioden-Barren 100, 101, 102, 103 bilden eine Laser-Dioden-Einheit 3.

Die Laser-Dioden-Barren 100, 101, 102, 103 pressen sich in das duktile Material der Kontaktfahne 12 und werden auf diese Weise mechanisch positioniert. Das Trägerelement 30, welches auch als Montageträger bezeichnet wird, erlaubt einen definierten Anpressdruck auf das Multi-Element-Paket. Hierzu kann eine zusätzliche Anpressvorrichtung 31 vorgesehen sein. Die zusätzliche Anpressvorrichtung 31 kann in Form von Schrauben, insbesondere in Form von Anpressschrauben vorgesehen sein. Es ist aber auch möglich, dass die Anpressvorrichtung insbesondere während des Montagevorganges als eine externe Anpressvorrichtung 31 temporär angewendet wird.

Damit die Laser-Dioden-Barren 100, 101, 102, 103 das Licht in definierter Weise abstrahlen können, was in Figur 1 durch die entsprechenden Dreiecke skizziert ist, welche die Abstrahlung symbolisieren, und weiterhin eine optimale, gleichmäßige Kühlung der Laser-Dioden-Barren 100, 101, 102, 103 erreicht werden kann, ist es insbesondere erforderlich, dass die Laser-Dioden-Barren 100, 101, 102, 103 bündig am oberen Ende der Kontaktfahnen 12 abschließen. Insbesondere gilt es zu verhindern, dass die Laser-Dioden-Barren 100, 101, 102, 103 schief eingeklemmt werden, oder das die die Klemmung bewirkenden Bauteile schief an den Laser-Dioden-Barren 100, 101, 102, 103 anliegen. Dies kann durch die Verwendung von wenigstens einem Abstandhalterelement 50 erreicht werden, welches unterhalb der Laser-Dioden-Barren 100, 101, 102, 103 angeordnet ist. In einer Ausführungsform kann das Abstandhalterelement 50 in Form eines Fadens, beispielsweise eines Nylonfadens, ausgebildet sein. Über die Art der verwendeten Abstandhalterelemente 50 insbesondere deren Dicke kann die erforderliche Höhe, die der Höhe der Laser-Dioden-Barren 100, 101, 102, 103 entspricht, eingestellt werden. In einer weiteren Ausführungsform kann das Abstandshalterelement in Form eine Streifens oder einer Platte z.B. aus Silikon ausgebildet sein. Weiterhin wird durch die Abstandshalterelemente auch die elektrische Isolierung sichergestellt, da sich auch die Abstandhalterelemente 50 im geklemmten Zustand zwischen den zwei Kontaktfahnen 12 beziehungsweise zwei Kühlisolator-Elementen 10 befinden.

Das Trägerelement 30 dient weiterhin der Kühlwasser-Zuführung, Kühlwasser-Abführung und Kühlwasser-Verteilung auf die beiden Befestigungsbacken 20.

Die Kühlisolator-Elemente 10 sollen mindestens so lang wie ein Laser-Dioden-Barren 100, 101, 102, 103 sein. Vorzugsweise weisen sie die Länge von zwei Laser-Dioden-Barren 100, 101, 102, 103 zuzüglich einer Zugabe für die Montageabstände zwischen den einzelnen Laser-Dioden-Barren 100, 101, 102, 103 auf. Das Kühlisolator-Element 10 kann auch dieselbe Länge haben wie die Summe aller montierten Laser-Dioden-Barren 100, 101, 102, 103 zuzüglich aller Montageabstände zwischen den Laser-Dioden-Barren 100, 101, 102, 103.

Bei einer Serienschaltung der Laser-Dioden-Barren sollten die Kontaktfahnen 12 vorzugsweise die Länge von zwei Laser-Dioden-Barren 100, 101, 102, 103 zuzüglich einer Zugabe für die Montageabstände zwischen den einzelnen Laser-Dioden-Barren 100, 101, 102, 103 haben. Die Kontaktfahnen 12 können auf den beiden Befestigungsbacken 20 wechselseitig versetzt angebracht sein, so dass eine serielle elektrische Beschaltung der Laser-Dioden-Barren 100, 101, 102, 103 erzielt wird. Die Laser-Dioden-Barren 100, 101, 102, 103 werden hierfür mit wechselseitiger Polung montiert. Auf diese Weise wird jeweils eine P-Seite eines Laser-Dioden-Barrens mit der N-Seite des benachbarten Laser-Dioden-Barrens elektrisch verbunden.

Die äußere elektrische Zuführung 13 befindet an einer oder beiden der Befestigungsbacken 20, wie in Figur 1 dargestellt ist. Bei einer geraden Anzahl von montierten Laser-Dioden-Barren 100, 101, 102, 103, beispielsweise 2, 4 oder 6 und so weiter, befinden sich die beiden äußeren elektrischen Zuführungen an einer Befestigungsbacke 20. Bei einer ungeraden Anzahl von montierten Laser-Dioden-Barren 100, 101, 102, 103, beispielsweise 1, 3 oder 5 und so weiter, befinden sich die elektrischen Zuführungen an beiden Befestigungsbacken 20.

Zur Montage der Laser-Dioden-Barren 100, 101, 102, 103 müssen diese relativ zu den Befestigungsbacken 20 horizontal mit hoher Präzision angeordnet werden. Dazu wird vorgesehen, die Laser-Dioden-Barren 100, 101, 102, 103 mit ihrer Austrittsfacette auf eine geeignete Auflageplatte aufzulegen und die Befestigungsbacken 20 über die Laser-Dioden-Barren 100, 101, 102, 103 zu positionieren. Die Auflageplatte darf keine Beschädigung der äußerst empfindlichen Austrittsfacetten hervorrufen. Die Auflageplatte kann daher eine Metallplatte z.B. ein polierte Edelstahlplatte oder eine Glasplatte sein. Zur exakten horizontalen Ausrichtung kann die Auflageplatte mit zusätzlichen Positionierelementen versehen sein. Dies können Markierungen auf der Auflageplatte oder geeignete Anschläge sein.

Zur exakten horizontalen Ausrichtung können auch externe Positioniervorrichtungen beispielsweise von Hand und/oder auch automatisiert zum Einsatz kommen. Die Laser-Dioden-Barren 100, 101, 102, 103 können mit Hilfe einer Vakuumvorrichtung, die in die Auflageplatte integriert ist, in ihrer Position fixiert werden.

Wichtig ist die exakte relative und/oder absolute Ausrichtung der Laser-Dioden-Barren 100, 101, 102, 103 auf der Auflageplatte. Die horizontale Ausrichtung sollte besser als 5 µm sein. Die Abstände der einzelnen Laser-Dioden sollten mit einer Genauigkeit von besser als 100 µm vorgenommen werden. Vorzugsweise wird, beispielsweise durch das Auflegen der Facetten auf die Auflageplatte, erreicht, dass die relative Ausrichtung der Facetten mit einer Genauigkeit von besser als 5 µm erfolgt. Die endgültige horizontale Ausrichtung erfolgt mit Hilfe der Befestigungsbacken 20.

Die Laser-Dioden-Barren 100, 101, 102, 103 werden durch Klemmen zwischen den beiden Befestigungsbacken 20 fixiert. Hierbei wird ausgenutzt, dass es, abhängig von der Druckbeaufschlagung durch die beiden Befestigungsbacken 20, zu einem Verformen der beiden duktilen Kontaktfahnen 12 kommt. Die Laser-Dioden-Barren 100, 101, 102, 103 werden hierdurch, und zwar jeder einzeln für sich, in das leicht verformbare Metall der Kontaktfahnen 12 hineingedrückt. Die äußere Form der Laser-Dioden-Barren wird in das Metall der Kontaktfahne 12 eingeprägt. Hierdurch kommt es neben einem Reibschluss zwischen dem Laser-Dioden-Barren und dem Metall der Kontaktfahne 12 zusätzlich zu einem Formschluss zwischen den beiden Elementen.

Bei einer nachfolgenden alternierenden Strombeaufschlagung der Laser-Dioden-Barren 100, 101, 102, 103 kommt es zu einem Ausdehnen, sofern die Laser-Dioden-Barren 100, 101, 102, 103 bestromt werden, und zu einem Zusammenziehen, sofern die Laser-Dioden-Barren 100, 101, 102, 103 unbestromt sind, der Laser-Dioden-Barren 100, 101, 102, 103. Dieser Effekt kann gezielt ausgenutzt werden, um eine zusätzliche Kontaktverbesserung zwischen der Goldauflage der Laser-Dioden-Barren 100, 101, 102, 103 und der Metalloberfläche der Kontaktfahnen 12 hervorzurufen.

Der Vorteil dieser Verbindungstechnik liegt darin, dass zur Befestigung und Kühlung der Laser-Dioden-Barren 100, 101, 102, 103 keine Lötverbindung verwendet werden muss. Lötverbindungen sind immer problematisch, da durch unterschiedliche thermische Ausdehnungskoeffizienten der beteiligten Fügepartner häufig innere Spannungen in das Halbleitermaterial der Laser-Dioden-Barren 100 eingebracht werden, was zu einer verminderten Lebensdauer der Laser-Dioden-Barren 100, 101, 102, 103 führt.

Insbesondere im so genannten Intervallbetrieb, bei dem sich in ständigen Intervallen der Laser-Dioden-Barren 100, 101, 102, 103 ausdehnt und wieder zusammenzieht, kann es zu einer Ermüdung der Lötverbindung mit nachfolgendem Versagen kommen.

Ein weiterer Vorteil der erfindungsgemäßen Klemmtechnik liegt in der Tatsache, dass die Laser-Dioden-Barren 100, 101, 102, 103 von der wasserdurchströmten Befestigungsbacke 20 elektrisch isoliert sind. Dies erlaubt zum einen die Verwendung nicht-entionisierten Wassers und damit den Einsatz kostengünstigerer Kühlsysteme.

Zum weiteren wird die Korrosion im kompletten Lasersystem mit allen seinen Elementen reduziert, da das Kühlwasser nicht Bestandteil des elektrischen Stromkreises ist.

Die Befestigungsbacken 20 können in unterschiedlichen Bauformen realisiert werden, beispielsweise über Mikrokanalkühler in Metallbauweise, insbesondere in Kupfer-Metallbauweise, über Kühler in Metall-Sinterbauweise, über Mikrokanalkühler in Keramik-Bauweise, über PIN-FIN-Kühler in Metall- oder Keramikbauweise oder über konventionell gefertigte Kühler in Metall- oder Keramikbauweise.

Die Klemmung der Laser-Dioden-Barren kann alternativ nur über die Befestigungsflächen und/oder durch außenseitig angebrachte Drück-Schrauben und/oder durch anderweitige Andrück- und/oder Anpress-Mechanismen und/oder durch innenseitig angebrachte Zug-Schrauben und/oder durch anderweitige Zug-Mechanismen erfolgen.

Die Kühlisolator-Elemente 10 können vorzugsweise auf den Wärmeaustauschflächen 201 der Befestigungsbacken 20 ausschließlich durch Klemmen mittels Reib-und/oder Formschluss befestigt werden. In einer weiteren Ausgestaltung kann/können ein oder mehrere Kühlisolator-Element/-e 10 zusätzlich auf der Wärmeaustauschfläche 201 fixiert werden. Dies kann beispielsweise mittels Klebung erfolgen. Hierzu können auf den Wärmeaustauschflächen 201 Taschen für die Aufnahme des Klebstoffes eingebracht werden. Alternativ können die Kühlisolator-Elemente 10 auf den Befestigungsbacken 20 auch mittels Löten oder einer sonstigen dauerhaft oder temporär wirkenden Verbindungstechnik befestigt werden.

Bei Kühlisolator-Elemente 10 deren Fläche deutlich größer ist als die Kontaktfläche der Laser-Dioden-Barren 100, 101, 102, 103 können Abstandshalterelemente 50 parallel zu den Laser-Dioden-Barren 100, 101, 102, 103 zwischen die gegenüberliegenden Kühlisolator-Elementen 10 und/oder Kontaktfahnen 12 eingefügt werden. Die Dicke dieser Abstandshalter muss an die Dicke der Laser-Dioden-Barren angepasst werden. Beim Klemmen wird auf diese Weise ein homogeneres Anpressen der Kühlisolator-Elemente 10 und damit ein besserer thermischer Kontakt der Kühlisolator-Elemente 10 zur Befestigungsbacke 20 erzielt.

Eine weitere Möglichkeit die Kühlleistung zu verbessern besteht darin, das Kühlisolator-Element 10 nicht auf die Wärmeaustauschfläche 201 zu pressen, sondern ihn in direkten Kontakt mit dem Kühlmedium zu bringen. Hierzu sollte vorzugsweise die Rückseite des Kühlisolator-Elements 10 vom Kühlmedium umspült werden. Das Kühlisolator-Element 10 könnte hierfür in eine entsprechende Öffnung der Wärmeaustauschfläche 201 oder auch direkt in die Befestigungsbacke 20 eingelassen werden.

Vorzugsweise verschließt das Kühlisolator-Element 10 dabei die Öffnung in der Wärmeaustauschfläche 201 oder der Befestigungsbacke 20. Die Ränder des Kühlisolator-Elements 10 sind hierfür dicht mit der Wärmeaustauschfläche 201 oder der Befestigungsbacke 20 verbunden. Diese Verbindung kann durch Kleben, Löten oder eine umlaufende Dichtung realisiert werden.

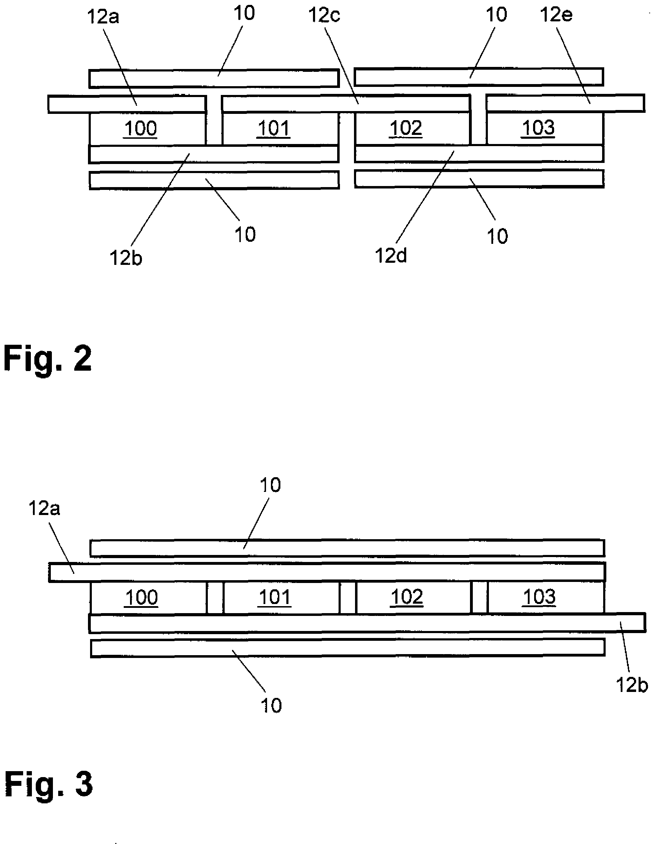

In Figur 2 ist ein Ausführungsbeispiel mit einer seriellen Verschaltung der einzelnen Laser-Dioden-Barren 100, 101, 102, 103 dargestellt. Die Laser-Dioden-Barren 100, 101, 102, 103 sind über Kontaktfahnen 12a, 12b, 12c, 12d, 12e in Serie geschaltet. Weiterhin sind auf jeder Seite der Laser-Dioden-Barren 100, 101, 102, 103 jeweils zwei Kühlisolator-Elemente 10 vorgesehen.

In Figur 3 ist ein Ausführungsbeispiel mit einer parallelen Verschaltung der einzelnen Laser-Dioden-Barren 100, 101, 102, 103 dargestellt. Die Laser-Dioden-Barren 100, 101, 102, 103 sind jeweils über Kontaktfahnen 12a, 12b parallel geschaltet.

### Bezugszeichenliste

- 1: Haltevorrichtung
- 2: Befestigungsvorrichtung
- 3: Laser-Dioden-Einheit
- 10: Kühlisolator-Element
- 11: Einrichtung zur Klemmbefestigung der Laser-Dioden-Barren
- 12: Kontaktfahne
- 12a: Kontaktfahne
- 12b: Kontaktfahne
- 12c: Kontaktfahne
- 12d: Kontaktfahne
- 12e: Kontaktfahne
- 13: Äußere elektrische Zuführung
- 20: Befestigungsbacke
- 30: Trägerelement
- 31: Anpressvorrichtung
- 40: Flüssigkeitszulauf
- 41: Flüssigkeitsablauf
- 50: Abstandhalterelement
- 100: Laser-Dioden-Barren
- 101: Laser-Dioden-Barren
- 102: Laser-Dioden-Barren
- 103: Laser-Dioden-Barren
- 200: Korpus
- 201: Wärmeaustauschfläche

## Patentansprüche

1. Haltevorrichtung (1) zum horizontalen Befestigen von wenigstens zwei in einer Linie nebeneinander angeordneten Laser-Dioden-Barren (100, 101, 102, 103), **dadurch gekennzeichnet, dass** die Haltevorrichtung (1) zum Klemmbefestigen der Laser-Dioden-Barren (100, 101, 102, 103) ausgebildet ist und wenigstens eine Einrichtung (11) zum Klemmbefestigen der Laser-Dioden-Barren (100, 101, 102, 103) aufweist.

2. Haltevorrichtung (1) nach Anspruch 1, **dadurch gekennzeichnet, dass** die Einrichtung (11) zum Klemmbefestigen der Laser-Dioden-Barren (100, 101, 102, 103) als Einrichtung zum formschlüssigen und/oder kraftschlüssigen Klemmbefestigen der Laser-Dioden-Barren (100, 101, 102, 103) ausgebildet ist und/oder dass die Haltevorrichtung (1) wenigstens zwei Kontaktfahnen (12) zur elektrischen Kontaktierung der Laser-Dioden-Barren (100, 101, 102, 103) aufweist, und dass wenigstens zwei Kontaktfahnen (12) als Einrichtung (11) zum Klemmbefestigen der Laser-Dioden-Barren (100, 101, 102, 103) ausgebildet ist oder eine solche Einrichtung (11) aufweist.

3. Haltevorrichtung (1) nach Anspruch 2, **dadurch gekennzeichnet, dass** wenigstens eine Kontaktfahne (12) zumindest bereichsweise aus einem duktilen Material besteht, wobei bevorzugt wenigstens eine Kontaktfahne (12) zumindest bereichsweise aus Kupfermaterial, insbesondere aus weichgeglühtem Kupfermaterial, besteht.

4. Haltevorrichtung (1) nach einem der Ansprüche 1 bis 3, **dadurch gekennzeichnet, dass** die Haltevorrichtung (1) wenigstens ein Kühlisolator-Element (10) aufweist, und dass bevorzugt die wenigstens eine Kontaktfahne (12) an dem wenigstens einen Kühlisolator-Element (10) angeordnet oder ausgebildet ist.

5. Befestigungsvorrichtung (2) zum horizontalen Befestigen von wenigstens zwei in einer Linie nebeneinander angeordneten Laser-Dioden-Barren (100, 101, 102, 103), **dadurch gekennzeichnet, dass** diese zum Klemmbefestigen der Laser-Dioden-Barren (100, 101, 102, 103) ausgebildet ist.

6. Befestigungsvorrichtung (2) nach Anspruch 5, **dadurch gekennzeichnet, dass** die Befestigungsvorrichtung (2) wenigstens eine Haltevorrichtung (1) nach einem der Ansprüche 1 bis 4 aufweist.

7. Befestigungsvorrichtung (2) nach Anspruch 5 oder 6, **dadurch gekennzeichnet, dass** diese wenigstens eine, vorzugsweise zwei Befestigungsbacken (20) aufweist, und dass bevorzugt wenigstens eine Befestigungsbacke (20) eine Kühleinrichtung und/oder eine Wärmeaustauschfläche (201) aufweist, und dass die Wärmeaustauschfläche (201) optional eine Kühleinrichtung aufweist oder als Kühleinrichtung ausgebildet ist.

8. Befestigungsvorrichtung (2) nach Anspruch 7, **dadurch gekennzeichnet, dass** auf wenigstens einer Befestigungsbacke (20) und/oder auf der Wärmeaustauschfläche (201) ein Kühlisolator-Element (10) der Haltevorrichtung (1) angeordnet ist.

9. Befestigungsvorrichtung (2) nach Anspruch 7 oder 8, **dadurch gekennzeichnet, dass** diese ein Trägerelement (30) aufweist, an dem die wenigstens eine Befestigungsbacke (20) angeordnet ist und/oder dass diese eine Anpressvorrichtung (31) zum Aufbringen eines definierten Pressdrucks auf die wenigstens eine Befestigungsbacke (20) aufweist.

10. Laser-Dioden-Einheit (3), mit wenigstens zwei horizontal in einer Linie nebeneinander angeordneten Laser-Dioden-Barren (100, 101, 102, 103) und mit einer Haltevorrichtung (1) nach einem der Ansprüche 1 bis 4 oder mit einer Befestigungsvorrichtung (2) nach einem der Ansprüche 5 bis 9.

11. Laser-Dioden-Einheit (3) nach Anspruch 10, **dadurch gekennzeichnet, dass** die Befestigungsvorrichtung (2) zwei Befestigungsbacken (20) aufweist an denen jeweils eine Haltevorrichtung (1) vorgesehen ist und dass die Laser-Dioden-Barren (100, 101, 102, 103) zwischen den Haltevorrichtungen (1) der zwei Befestigungsbacken (20) eingeklemmt sind und/oder dass auf beiden Seiten der Laser-Dioden-Barren (100, 101, 102, 103) wenigstens eine Kontaktfahne (12) und/oder ein Kühlisolator-Element (10) der Haltevorrichtung (1) vorgesehen ist und/oder dass die Laser-Dioden-Barren (100, 101, 102, 103) über die wenigstens eine Kontaktfahne (12) der Haltevorrichtung (1) seriell oder parallel verschaltet sind.

12. Laser-Dioden-Einheit (3) nach Anspruch 10 oder 11, **dadurch gekennzeichnet, dass** zwischen den Haltevorrichtungen (1) der beiden Befestigungsbacken (20) weiterhin wenigstens ein Abstandhalterelement (50) vorgesehen ist.

13. Verfahren zum Herstellen einer Laser-Dioden-Einheit (3), insbesondere einer Laser-Dioden-Einheit (3) nach einem der Ansprüche 10 bis 12, wobei die Laser-Dioden-Einheit (3) wenigstens zwei horizontal in einer Linie nebeneinander angeordnete Laser-Dioden-Barren (100, 101, 102, 103) aufweist, und wobei die Laser-Dioden-Barren (100, 101, 102, 103) mittels einer Befestigungsvorrichtung (2), insbesondere mit wenigstens einer, vorzugsweise zwei Befestigungsbacken (20), befestigt werden, **dadurch gekennzeichnet, dass** die Laser-Dioden-Barren (100, 101, 102, 103) durch Klemmen horizontal an/in der Befestigungsvorrichtung (2) fixiert werden.

14. Verfahren nach Anspruch 13, bei dem die Befestigungsvorrichtung (2) zwei Befestigungsbacken (20) aufweist, wobei jede Befestigungsbacke (20) eine Haltevorrichtung (1) mit wenigstens einer Kontaktfahne (12) zur elektrischen Kontaktierung der Laser-Dioden-Barren (100, 101, 102, 103) aufweist, und wobei die wenigstens eine Kontaktfahne (12) zumindest bereichsweise aus einem duktilen Material besteht, **dadurch gekennzeichnet, dass** die Laser-Dioden-Barren (100, 101, 102, 103) in das duktile Material der Kontaktfahne(n) (12) eingepresst werden.

15. Verfahren nach einem der Ansprüche 13 oder 14, **dadurch gekennzeichnet, dass** die Laser-Dioden-Barren (100, 101, 102, 103) während der Montage mit ihren Austrittfacetten auf eine Auflageplatte aufgelegt werden, dass die Laser-Dioden-Barren (100, 101, 102, 103) auf der Auflageplatte horizontal ausgerichtet werden, dass die wenigstens eine Befestigungsbacke (20) der Befestigungsvorrichtung (2) über den Laser-Dioden-Barren (100, 101, 102, 103) positioniert wird, und dass anschließend die Laser-Dioden-Barren (100, 101, 102, 103) durch Klemmen an/in der Befestigungsvorrichtung (2) fixiert werden.
